# EUROPÄISCHE PATENTSCHRIFT

(11) **EP 1 996 953 B1**
(45) Veröffentlichungstag und Bekanntmachung des Hinweises auf die Patenterteilung: **24.06.2009**
(21) Anmeldenummer: 07724631.2
(22) Anmeldetag: 26.04.2007
(51) Int. Cl.: G01R 21/01, G01R 19/25, G01R 19/02, G01R 19/04

(54) **MESSVORRICHTUNG UND MESSVERFAHREN ZUM MESSEN DER HÜLLKURVENLEISTUNG UND DES LEISTUNGSMITTELWERTS**
MEASURING DEVICE AND MEASURING METHOD FOR MEASURING THE POWER ENVELOPE AND THE AVERAGE POWER
DISPOSITIF ET PROCÉDÉ DE MESURE DE LA PUISSANCE D'ENVELOPPE ET DE LA VALEUR MOYENNE

(30) Priorität: 26.05.2006 DE 102006024698; 14.08.2006 DE 102006038031
(43) Veröffentlichungstag der Anmeldung: 03.12.2008
(73) Patentinhaber: Rohde & Schwarz GmbH & Co. KG, 81671 München (DE)
(72) Erfinder: REICHEL, Thomas, 85598 Baldham (DE); BRATFISCH, Toralf, 85640 Putzbrunn (DE); KATZER, Michael, 80337 München (DE)
(74) Vertreter: Körfer, Thomas
(86) Internationale Anmeldenummer: PCT/EP2007/003701
(87) Internationale Veröffentlichungsnummer: WO 2007/137658

(56) Entgegenhaltungen:
- WO-A-01/36988
- GB-A- 2 067 373
- US-A- 4 968 987
- US-A- 5 493 298
- US-B1- 6 362 677

## Beschreibung

Die Erfindung betrifft eine Messvorrichtung zum Messen der Hüllkurvenleistung und des Leistungsmittelwerts eines Hochfrequenzsignals.

Eine Messvorrichtung nach dem Oberbegriff des Anspruchs 1 ist aus der DE 199 55 342 A1 bekannt. Mit der aus dieser Druckschrift hervorgehenden Messvorrichtung kann sowohl die Hüllkurvenleistung als auch der Leistungsmittelwert bzw. Effektivwert gemessen werden. Um einen möglichst großen Dynamikbereich abzudecken, ist der Messbereich in mehrere Teilbereiche aufgeteilt, die jeweils mehreren parallel angeordneten Messzweigen zugeordnet sind. In jedem Messzweig ist jeweils ein Zerhacker (Chopper) angeordnet, wobei beide synchron angesteuert werden. Außerdem ist in jedem Messzweig ein Analog/Digital-Wandler angeordnet, der mit einer synchronen Taktrate versorgt wird. Nach gewichteter Addition der digitalisierten Messsignale der einzelnen Messzweige erfolgt eine synchrone Demodulation, bevor das Signal ausgewertet wird.

Nachteilig bei der aus der DE 199 55 342 A1 bekannten Messvorrichtung ist die Verwendung paralleler Messzweige, wodurch die Messvorrichtung sehr aufwendig gestaltet ist. Neben der Synchronisierung der Chopper und der Analog/Digital-Wandler ist dafür Sorge zu tragen, dass die Gruppenlaufzeit des Messsignals in allen Messzweigen exakt gleich groß ist. Dies bereitet in der Praxis insbesondere bei zu realisierenden Video-Bandbreiten in der Größenordnung von 30 MHz Schwierigkeiten. Bei einer nur einpfadigen Realisierung der Messvorrichtung muss dafür Sorge getragen werden, dass der Analog/Digital-Wandler am oberen Ende des Dynamikbereichs nicht übersteuert wird. Dies führt am unteren Ende des Dynamikbereichs zu einer nur geringen Aussteuerung. Es müssen daher besondere Maßnahmen getroffen werden, um trotzdem eine hohe Messgenauigkeit sicher zu stellen.

Dither-Verfahren sind z.B. aus GB 2 067 373 A, US 5,493,298 A sowie US 4,968,987 A bekannt.

Der Erfindung liegt die Aufgabe zugrunde, eine Messvorrichtung und ein Messverfahren zum Messen der Hüllkurvenleistung und des Leistungsmittelwerts eines Hochfrequenzsignals zu schaffen, welche bzw. welches trotz Verwendung nur eines einzigen Messzweigs eine hohe Messgenauigkeit ermöglicht.

Die Aufgabe wird bezüglich der Messvorrichtung durch die Merkmale des Anspruchs 1 und bezüglich des Messverfahrens durch die Merkmale des Anspruchs 10 gelöst. Die abhängigen Ansprüche enthalten vorteilhafte Weiterbildungen der Erfindung.

Erfindungsgemäß wird vorgeschlagen, vor der Analog/Digital-Wandlung ein Dithersignal einzuspeisen, wobei für die Messung der Hüllkurvenleistung ein anderes Dithersignal verwendet wird als bei der Messung des Leistungsmittelwerts. Dies ermöglicht eine optimale Anpassung des Dithersignals an die Messaufgabe.

Wenn die Hüllkurvenleistung gemessen wird, sollte das Dithersignal während einer Aufnahme der Messreihe nicht verändert werden. Typischerweise werden mehrere Messreihen hintereinander aufgenommen. Beispielsweise interessiert der Verlauf der Hüllkurvenleistung während eines Sendebursts eines Mobilfunksignals. In der Regel wird dann ein Trigger gesetzt, bei dessen Überschreiten die Messaufnahme beginnt und während einer vorgegebenen Zeitdauer, über die sich der Burst erstreckt, die Hüllkurvenleistung detektiert. Während dieser Messaufnahme sollte dann das zur Messung der Hüllkurvenleistung verwendete erste Dithersignal konstant gehalten werden. Während die Messvorrichtung dann auf den nächsten Burst wartet, sollte das Dithersignal variiert werden, so dass die nächste Messaufnahme für den nächsten Burst mit einer anderen Ditherung vorgenommen wird. Die Ditherung mit dem zu dem eigentlichen Messsignal addierten Dithersignal bewirkt dann, dass die Diskretisierungsschwellen des Analog/Digital-Wandlers relativ zu dem Messsignal sich an einer anderen Positionen befinden und bei einer Mittelung über mehrere Messaufnahmen die Diskretisierungsfehler herausgemittelt werden.

Soll der Leistungsmittelwert gemessen werden, so ist es vorteilhaft ein anderes Dithersignal zu verwenden, nämlich ein solches, das sich von Abtastwert zu Abtastwert ständig ändert und somit durch kontinuierliche Variation der Diskretisierungsschwellen des Analog/Digital-Wandlers relativ zu dem Messsignal eine optimale Unterdrückung des Diskretisierungsfehlers ermöglicht. Zur Erfassung des Leistungsmittelwerts ist es nicht erforderlich, dass das Messsignal während der Messaufnahme nicht verändert wird, denn aufgrund der bei der Berechnung des Leistungsmittelwerts vorgenommenen Mittelung der einzelnen gemessenen Leistungswerte verschwindet die durch die Ditherung hervorgerufene Variation der einzelnen Leistungswerte im statistischen Mittel.

Bei dem für die Messung der Hüllkurvenleistung verwendeten ersten Dithersignal handelt es sich um ein abschnittsweise konstantes Signal, das mit einer großen Amplitudenvariation mit gleicher relativer Häufigkeit der Einzelwerte erzeugt wird. Zur Erzeugung eines solchen Signals eignet sich beispielsweise ein Zähler, der kontinuierlich hochgezählte Digitalworte erzeugt. Wird bei der Interpretation des Zählerergebnisses die Wertigkeit der Bits vertauscht, d. h. das niedrigstsignifikanteste Bit (LSB) mit dem meistsignifikantesten Bit (MSB) in einer Zweierkomplementär-Darstellung vertauscht, so entsteht eine Digitalwertfolge, die kontinuierlich ihr Vorzeichen und ihre Amplitude ändert. Durch Digital/Analog-Wandlung kann ein Analogsignal erzeugt werden, das dem Messsignal vor der Analog/Digital-Wandlung zugesetzt werden kann. Die Eliminierung in dem äquivalenten Digitalsignal nach der Analog/Digital-Wandlung kann in sehr einfacher Weise dadurch erfolgen, dass der Digitalwert des Dithersignals von dem Digitalwert wieder abgezogen wird bzw. mit invertierten Vorzeichen addiert wird.

Als das zweite Dithersignal für die Messung des Leistungsmittelwerts eignet sich beispielsweise ein phasenmoduliertes Sinussignal, welches zumindest teilweise aus dem digitalen Signal durch ein als Bandsperre arbeitendes digitales Filter eliminiert werden kann. Die Tatsache, dass das phasenmodulierte Signal nicht vollständig eliminiert werden kann, ist auf Grund der Mittellung unschädlich.

Zur Verringerung des 1/f-Rauschens und zur Verringerung des Einflusses einer thermischen Drift des Gleichspannungsverstärkers ist es vorteilhaft, vor dem Gleichspannungsverstärker einen Zerhacker (Chopper) anzuordnen. Die durch das Choppen verursachte Signal-Inversion kann durch einen Synchrondemodulator im Digitalsignal wieder beseitigt werden.

Ein Ausführungsbeispiel der Erfindung wird nachfolgend unter Bezugnahme auf die Zeichnung beispielhaft näher beschrieben. In der Zeichnung zeigen:
- Fig. 1: eine Messvorrichtung nach dem Stand der Technik;
- Fig. 2: ein Ausführungsbeispiel der erfindungsgemäßen Messvorrichtung in einem ersten Modus A zur Messung der Hüllkurvenleistung;
- Fig. 3: das Ausführungsbeispiel der erfindungsgemäßen Messvorrichtung in einem zweiten Modus B zur Messung des Leistungsmittelwerts;
- Fig. 4: ein detaillierteres Blockschaltbild des Ausführungsbeispiels der erfindungsgemäßen Messvorrichtung;
- Fig. 5: eine schematische Darstellung der von dem Zähler in Fig. 4 erzeugten Digitalworte und deren Interpretation am Eingang des in Fig. 4 dargestellten Digital/Analog-Wandlers;
- Fig. 6A: das erste Dithersignal Dither A am Ausgang des Digital/Analog-Wandlers in Fig. 4;
- Fig. 6B: ein zu vermessendes Burstsignal im Bezug zu dem in Fig. 6A dargestellten ersten Dithersignal und
- Fig. 7: das Spektrum des phasenmodulierten zweiten Dithersignals Dither B.

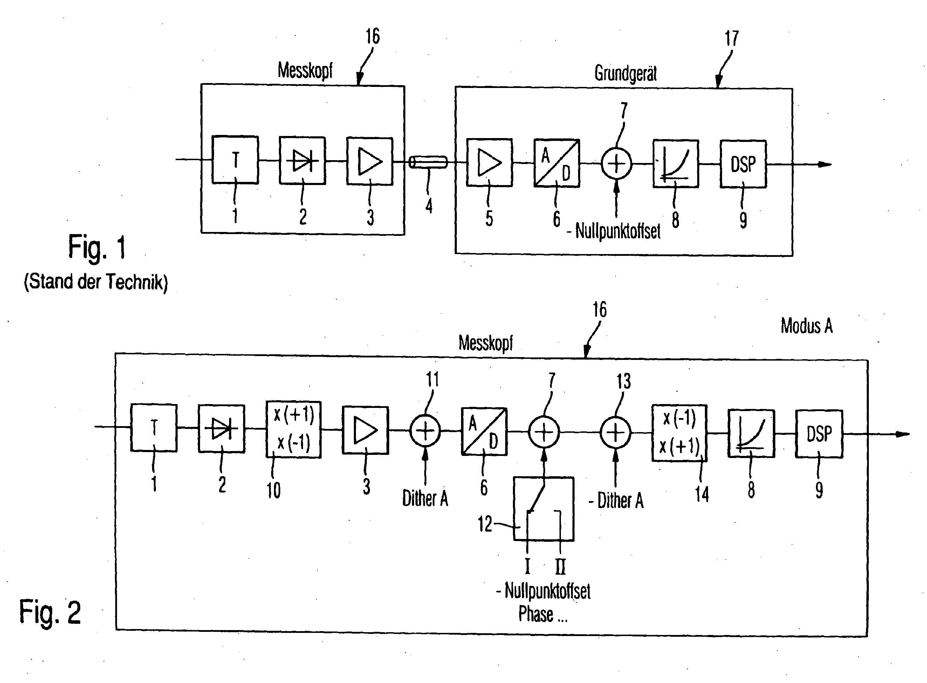

Fig. 1 zeigt eine bislang übliche Konfiguration einer Messvorrichtung zum Messen der Hüllkurvenleistung und des Leistungsmittelwerts. In einem Messkopf 16 sind ein Dämpfungsglied 1, ein Hüllkurven-Detektor 2, der als Dioden-Detektor ausgebildet sein kann; und ein Vorverstärker bzw. Leitungstreiber 3 angeordnet. Der Messkopf 16 ist über ein Verbindungskabel 4 mit dem Grundgerät 17 verbunden. In dem Grundgerät 17 befindet sich der Hauptverstärker 5, ein Analog/Digital-Wandler 6, eine Summierstufe 7 zur Subtraktion des Nullpunkt-Offsets, eine Einrichtung 8 zur Kennlinienkorrektur und ein digitaler Signalprozessor mit weiteren Auswertefunktionen, beispielsweise zur Hüllkurvenanzeige, zur Berechnung des Leistungsmittelwerts usw.. Die Einrichtung zur Kennlinienkorrektur 8 und der digitale Signalprozessor 9 bilden zusammen eine Auswerteeinrichtung 8, 9.

Fig. 2 zeigt ein Ausführungsbeispiel der erfindungsgemäßen Messvorrichtung in einem ersten Modus A, der zur Messung der Hüllkurvenleistung dient. Ein Unterschied zu der Konfiguration nach Fig. 1 besteht darin, dass sämtliche Komponenten der erfindungsgemäßen Messvorrichtung bevorzugt im Messkopf 16 angeordnet sein können. Ein spezielles Grundgerät nur für die Leistungsmessung ist dann unter Umständen nicht mehr notwendig. Der Messkopf 17 kann beispielsweise über einen USB-Bus unmittelbar an einen PC angeschlossen werden.

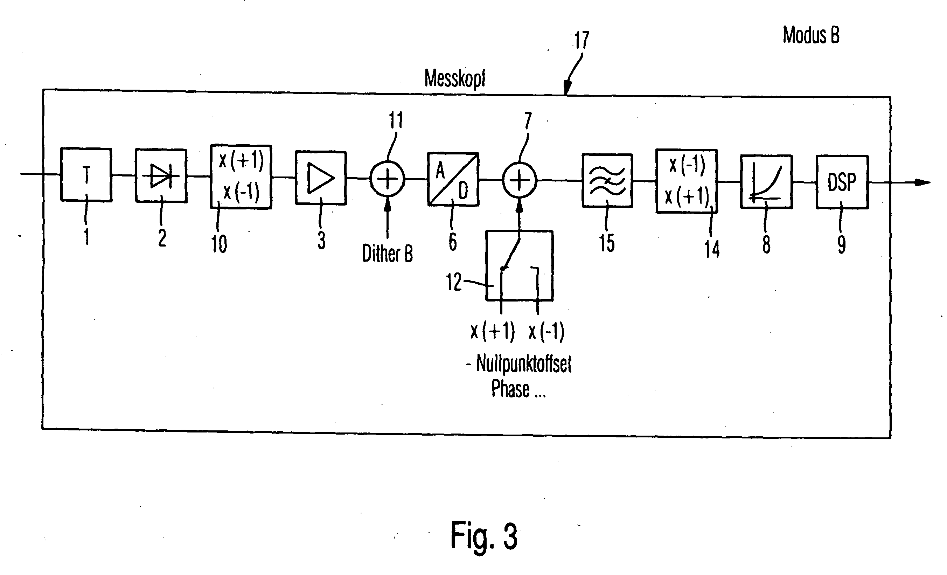

Der wesentliche Unterschied besteht aber darin, dass zwischen dem Detektor 2 und dem Analog/Digital-Wandler 6 bevorzugt nach dem Verstärker 3, eine Einspeiseeinrichtung 11 zum Einspeisen eines Dithersignals angeordnet ist. Dabei speist die Einspeiseeinrichtung 11 für die Messung der Hüllkurvenleistung ein erstes Dithersignal Dither A ein und für die Messung des Leistungsmittelwerts ein anderes, in Fig. 3 veranschaulichtes zweites Dithersignal Dither B ein.

Der Wert des ersten Dithersignals Dither A wird während der Aufnahme einer aus mehreren Messwerten der Hüllkurvenleistung bestehenden Messwertereihe nicht verändert, sondern nur zwischen den einzelnen Messwerte-Aufnahmen variiert. Dies wird später noch veranschaulicht. Das erste Ditherisgnal Dither A kann an einer Dither-Eliminierungseinrichtung 13 aus dem durch den Analog/Digital-Wandler 6 digitalisierten Messsignal wieder eliminiert werden. Im in Fig. 2 dargestellten Ausführungsbeispiel besteht die Dither-Eliminierungseinrichtung 11 für das erste Dithersignal Dither A aus einem Addierer, welchem das digitale Äquivalent des ersten Dithersignals mit invertiertem Vorzeichen (-Dither A) zugeführt wird, so dass das digitale Äquivalent des ersten Dithersignals von dem digitalisierten Messsignal subtrahiert wird.

Außerdem ist zwischen dem Detektor 2 und dem Gleichspannungsverstärker 3 ein Zerhacker (Chopper) 10 angeordnet. Der Chopper 10 zerhackt das Messsignal, indem zyklisch das Vorzeichen des analogen Signals invertiert wird. Das Zerhacken hat den Vorteil, das der Einfluss der thermischen Drift des Gleichspannungsverstärkers 3 erheblich reduziert wird. Des weiteren wird der Einfluss des 1/f-Rauschens reduziert. Hinter dem Analog/DigitalWandler 6 befindet sich ein Synchrondemodulator 14, der das digitalisierte Messsignal synchron zu dem Chopper 10 mit -1 bzw. +1 multipliziert und somit den Einfluss des Choppers 10 eliminiert. Dieser Vorzeichenwechsel kann ohne echte Multiplikation nummerisch sehr einfach vollzogen werden.

Eine weitere Besonderheit bei dem in Fig. 2 dargestellten Ausführungsbeispiel besteht noch darin, dass die Einrichtung 7, 12 zur Korrektur des Nullpunktversatzes eine Umschalteinrichtung 12 aufweist, welche eine unterschiedliche Nullpunkt-Korrektur für die beiden Chop-Phasen +1 und -1 des Choppers 10 ermöglicht. Die Nullpunkt-Offsets können für die beiden Chop-Phasen in einer nicht dargestellten Speichereinrichtung unabhängig voneinander gespeichert werden. Die Umschalteinrichtung 12 wird synchron zu dem Chopper 10 betrieben.

Fig. 3 zeigt das anhand von Fig. 2 bereits beschriebene Ausführungsbeispiel des erfindungsgemäßen Messkopfs 16 in einem zweiten Modus B, der zur Erfassung des Leistungsmittelwerts des zu messenden Hochfrequenzsignals dient. Erfindungsgemäß wird für die Messung des Leistungsmittelwerts ein zweites Dithersignal Dither B verwendet, das sich von dem ersten Dithersignal Dither A grundlegend unterscheidet. Bevorzugt wird als zweites Dithersignal Dither B ein phasenmoduliertes Sinussignal verwendet. Es sind jedoch auch eine Vielzahl anderer Möglichkeiten denkbar, beispielsweise ein frequenzmoduliertes Sinussignal oder ggf. auch ein amplitudenmoduliertes Signal.

Das zweite Dithersignal Dither B wird auch im Modus B über die Einspeiseeinrichtung 11 vor dem Analog/Digital-Wandler 6 eingespeist. Das phasenmodulierte Sinussignal hat vorzugsweise eine Frequenz zwischen der maximalen Frequenz des Messsignals und der Abtastfrequenz des Analog/DigitalWandlers 6. Dieses Dithersignal führt dazu, dass jeder Abtastwert etwas anders verändert wird. Dadurch wird sehr schnell eine wirkungsvolle Ditherung erreicht. Allerdings wird dabei auch die Hüllkurve des Signals verändert, weshalb sich das zweite Dithersignal Dither B nicht für die Messung der Hüllkurvenleistung eignet.

Um zumindest einen großen Anteil des zweiten Dithersignals Dither B zu eliminieren ist im digitalen Signalpfad vorzugsweise eine Bandsperre 15 vorhanden, die als digitales Filter implementiert ist. Durch diese Bandsperre 15 lässt sich das zweite Dithersignal Dither B jedoch nicht vollständig eliminieren. Dies ist aber für die Bestimmung des Leistungsmittelwerts unschädlich, da in dem digitalen Signalprozessor 9 der Auswerteeinrichtung 8, 9 der Mittelwert der einzelnen gemessenen Leistungspegel berechnet wird und bei einer symmetrischen Verteilung der relativen Häufigkeit der einzelnen Amplitudenwerte des Dithersignals Dither B dieses Dithersignal bei einer Mittelung über eine genügend große Anzahl von Einzelwerten keinen Einfluss mehr auf den berechneten Mittelwert hat.

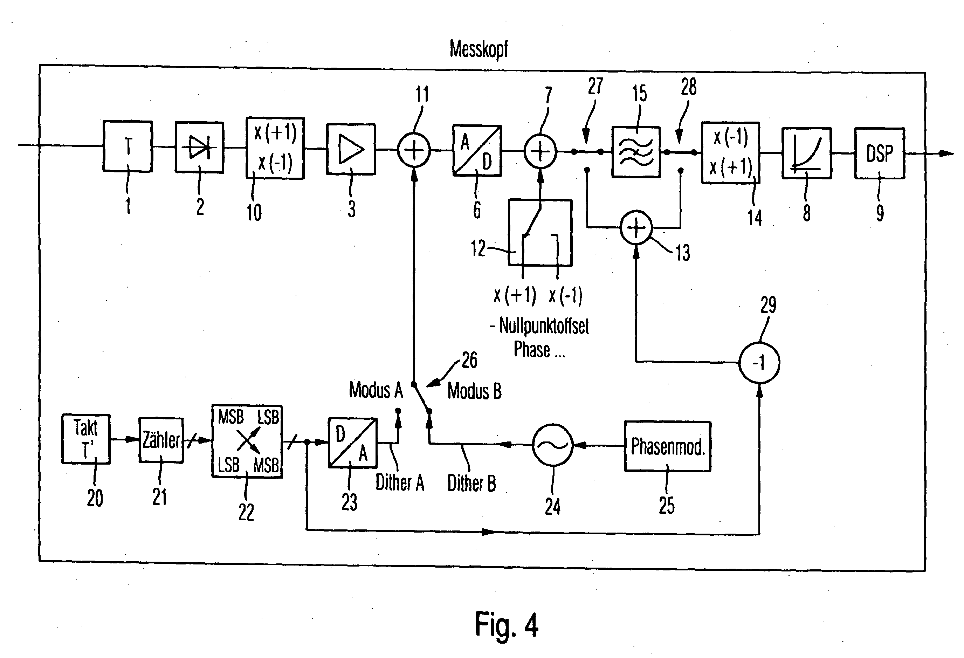

Fig. 4 zeigt ein detaillierteres Blockschaltbild, bei welchem die beiden in Fig. 2 und Fig. 3 dargestellten Modi A und B zusammengefasst sind. Zwischen dem Modus A und dem Modus B wird mit den Umschaltelementen 26, 27 und 28 umgeschaltet. Das Umschaltelement 26 führt im Modus A das Dithersignal Dither A und im Modus B das Dithersignal Dither B der Einspeiseeinrichtung 11 zu.

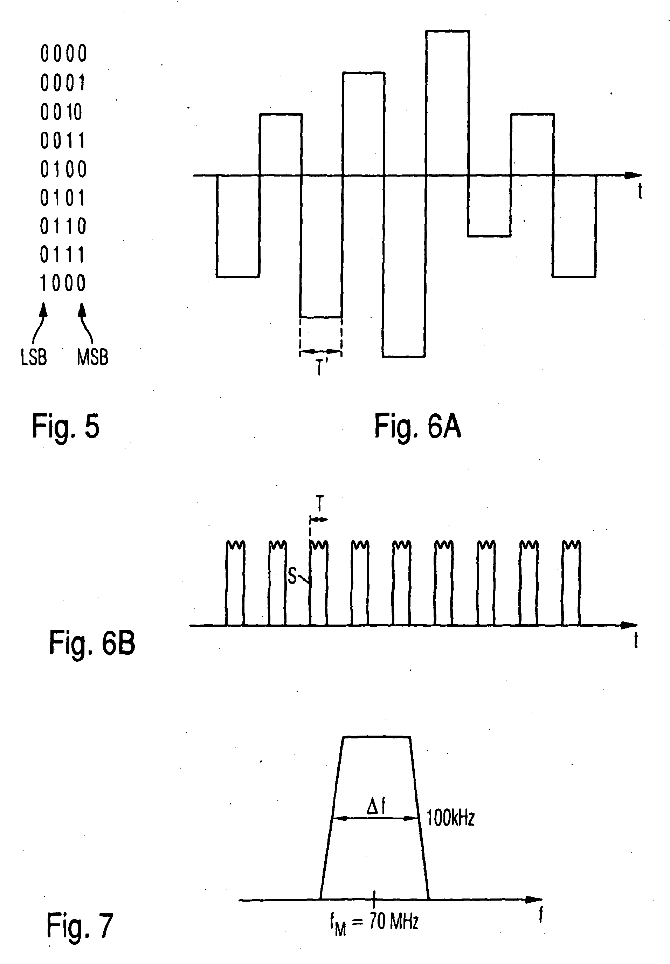

In Fig. 4 ist ein Ausführungsbeispiel zur Erzeugung des Dithersignals Dither A dargestellt. Bei diesem Ausführungsbeispiel zählt ein Zähler 21 im Takt der von dem Taktgenerator 20 vorgegebenen Taktrate kontinuierlich aufwärts. Für das vereinfachte Beispiel eines 4-stelligen Zählers ist das Datenwort am Ausgang des Zählers 21 in Fig. 5 angegeben. In der Einheit 22 werden nun die Wertigkeiten der einzelnen Bits des von dem Zähler 21 erzeugten Digitalworts vertauscht, d. h. das niedrigwertigste Bit LSB wird zum höchstwertigsten Bit MSB, das höchstwertigste Bit MSB wird zum niedrigstwertigsten Bit LSB, das zweitniedrigwertigste Bit wird zum zweithöchstwertigsten Bit, das zweithöchstwertigste Bit zum zweitniedrigwertigsten Bit usw. Diese vertauschte Interpretation der Bitwertigkeit des von dem Zähler 21 erzeugten Datenworts ist in Fig. 5 mit LSB und MSB gekennzeichnet.

Interpretiert man das in seiner Bitwertigkeit vertauschte Datenwort nun in einer Zweier-Komplementärdarstellung, bei welcher das höchstwertigste Bit MSB das Vorzeichen des Datenworts charakterisiert und gibt man diese Datenfolge auf einen Digital/Analog-Wandler 23, so entsteht ein Analog-Signal, das in Fig. 6A veranschaulicht ist. Es handelt sich dabei um ein Rechtecksignal, dessen Vorzeichen sich entsprechend der von dem Taktgenerator 20 vorgegebenen Taktrate ändert, wobei die Amplituden von Impuls zu Impuls treppenförmig ansteigt und wieder abfällt.

Ist das Umschaltelement 26 in die mit Modus A gekennzeichnete Schaltstellung geschaltet, so wird das von dem Digital/Analog-Wandler 23 erzeugte Dithersignal Dither A der Einspeiseeinrichtung 11 zugeführt und überlagert sich dort dem Messsignal. In Fig. 6B ist die Aufnahmezeit T, während welcher die Hüllkurvenleistung von der erfindungsgemäßen Messvorrichtung erfasst wird, in Bezug auf die Dauer T' einer Halbwelle des ersten Dithersignals Dither A schematisch veranschaulicht. Das in Fig. 6B sehr schematisch dargestellte Messbeispiel geht davon aus, dass das zu messende Hochfrequenzsignal aus mehreren Bursts besteht, wie dies bei Mobilfunksignalen insbesondere nach dem GSM-Standard üblich ist. Nachdem der Leistungspegel über einen Schwellwert S angestiegen ist, soll der zeitliche Verlauf der Hüllkurvenleistung, die unter anderem von der Modulation abhängt, aufgezeichnet werden.

Während der Aufzeichnungsdauer T bleibt das Dithersignal Dither A konstant, so dass durch das bei Messung der Hüllkurvenleistung verwendete Dithersignal Dither A die Hüllkurve des Messsignals nicht verändert wird. Nur zwischen den einzelnen Aufnahmen, im in Fig. 6B dargestellten Messbeispiel also zwischen den Bursts, wird das Dithersignal Dither A verändert, so dass es bei der nächsten Messaufnahme mit einem anderen Vorzeichen und einer anderen Amplitude vorliegt. Für jede Aufnahme ist der Dither-Wert daher etwas verändert, so dass die Diskretisierungsschwellen des Analog/Digital-Wandlers relativ zu dem Messsignal bei jeder Aufnahme etwas variiert werden. Wird beim sog. "Averaging"-Betrieb nachfolgend über sämtliche Aufnahmen gemittelt, wird dadurch nicht nur das Signal/Rausch-Verhältnis verbessert, sondern auch der Diskretisierungsfehler des Analog/Digital-Wandlers verringert. Wichtig ist aber, dass sich das Dithersignal Dither A während der Messaufnahme nicht ändert.

Der dem ersten Dithersignal Dither A entsprechende Digitalwert wird über einen Invertierer 27, welcher das Vorzeichen des Digitalwerts invertiert, auf den Addierer 13 gegeben und dort vom digitalisierten Messsignal abgezogen. Natürlich könnte statt eines Addierers 13 auch ein Subtrahierer verwendet werden und der Invertierer 29 weggelassen werden. Die Umschaltelemente 27 und 28 befinden sich dabei nicht in der in Fig. 4 dargestellten Schaltstellung, sondern in der anderen Schaltstellung.

Wie bereits erläutert, wird zur Messung des Leistungsmittelwerts ein anderes Dithersignal Dither B verwendet, das nicht während der gesamten Messaufnahme konstant gehalten wird, sondern von Abtastwert zu Abtastwert des Digital/Analog-Wandlers 6 variiert wird. Dies kann beispielsweise dadurch erreicht werden, dass ein Sinusgenerator 24 durch einen Phasenmodulator 25 phasenmoduliert wird. In Fig. 7 ist das Spektrum dieses phasenmodulierten Sinussignals, das als zweites Dithersignal Dither B verwendet wird, schematisch dargestellt. Die Frequenz variiert innerhalb einer Bandbreite Δf um beispielsweise 100 kHz um eine Mittenfrequenz f_{M} von beispielsweise 70 MHz herum. Die Mittenfrequenz f_{M} sollte zwischen der maximalen Signalfrequenz des Messsignals und der Abtastfrequenz des Analog/Digital-Wandlers 6 liegen. Dieses sich ständig ändernde zweite Dithersignal Dither B führt dazu, dass jeder Abtastwert etwas verändert wird. Dadurch wird sehr schnell eine wirkungsvolle Ditherung erreicht. Allerdings ändert dies auch die Hüllkurve des Signals, so dass sich das Dithersignal Dither B für die Messung der Hüllkurvenleistung nicht eignet. Deswegen wird das an sich wirkungsvollere Dithersignal Dither B nur für die Bestimmung der Leistungsmittelwerte verwendet.

Die Erfindung ist nicht auf das dargestellte Ausführungsbeispiel beschränkt. Bei dem Dithersignal Dither A ist es zwar vorteilhaft, aber nicht zwingend erforderlich, dass sich das Vorzeichen des Dithersignals von Takt zu Takt ändert. Das zweite Dithersignal Dither B kann auch in anderer Weise erzeugt werden, beispielsweise indem eine pseudozufällige Binärfolge auf einen Digital/Analog-Wandler gegeben wird.

## Patentansprüche

1. Messvorrichtung zum Messen der Hüllkurvenleistung und des Leistungsmittelwerts eines Hochfrequenzsignals mit einem Detektor (2) zum Detektieren des Hochfrequenzsignals und zum Erzeugen eines analogen Detektorsignals, einem Analog/Digital-Wandler (6) zum Erzeugen eines digitalen Signals und
einer Auswerteeinrichtung (8, 9) zur Auswertung des digitalen Signals,
**dadurch gekennzeichnet,**
**dass** zwischen dem Detektor (2) und dem Analog/DigitalWandler (6) eine Dither-Einspeiseeinrichtung (11) zum Einspeisen eines Dithersignals angeordnet ist, wobei die Dither-Einspeiseeinrichtung (11) für die Messung der Hüllkurvenleistung ein anderes Dithersignal als für die Messung des Leistungsmittelwerts einspeist und
wobei sie für die Messung der Hüllkurvenleistung ein erstes Dithersignal (Dither A) einspeist, welches während der Aufnahme einer aus mehreren Messwerten der Hüllkurvenleistung bestehenden Messwertereihen nicht verändert wird, aber zwischen den Aufnahmen der Messwertereihen mit einer großen Amplitudenvariation variiert wird, und
wobei sie für die Messung des Leistungsmittelwerts ein zweites Dithersignal (Dither B) einspeist, das kontinuierlich variiert wird.

2. Messvorrichtung nach Anspruch 1,
**dadurch gekenntzeichnet,**
**dass** das erste Dithersignal (Dither A) über einen Digital/Analog-Wandler (23) aus einer zyklischen Digitalwertefolge erzeugt wird, wobei benachbarte Digitalwerte der Digitalwertefolge im statistischen Mittel einen relativ großen Werteunterschied haben.

3. Messvorrichtung nach Anspruch 2,
**dadurch gekennzeichnet,**
**dass** die zyklische Digitalwertefolge mittels eines Zählers (21) erzeugt wird, wobei das höchstsignifikanteste Bit (MSB) jedes von dem Zähler (21) erzeugten Digitalwerts als niedrigstsignifikantestes Bit (LSB) des Digital/Analog-Wandlers (23) und das niedrigstsignifikanteste Bit (LSB) jedes von dem Zähler (21) erzeugten Digitalwerts als höchstsignifikantestes Bit (MSB) des Digital/Analog-Wandlers (23) benutzt wird.

4. Messvorrichtung nach Anspruch 2 oder 3,
**dadurch gekennzeichnet,**
**dass** zwischen dem Analog/Digital-Wandler (6) und der Auswerteeinrichtung (8, 9) eine Dither-Eliminationseinrichtung (13) zum Eliminieren des ersten Dithersignals (Dither A) angeordnet ist.

5. Messvorrichtung nach Anspruch 1,
**dadurch gekennzeichnet,**
**dass** das zweite Dithersignal (Dither B) durch einen Oszillator (24) erzeugt ist, der innerhalb einer vorgegebenen Bandbreite um eine vorgegebene Mittenfrequenz (f_{M}) durch einen Phasenmodulator (25) phasenmoduliert wird.

6. Messvorrichtung nach Anspruch 5,
**dadurch gekennzeichnet,**
**dass** der Oszillator (24) ein phasenmoduliertes Sinussignal erzeugt.

7. Messvorrichtung nach Anspruch 5 oder 6,
**dadurch gekennzeichnet,**
**dass** zwischen dem Analog/Digital-Wandler (6) und der Auswerteeinrichtung (8, 9) eine Bandsperre (15) zum zumindest teilweisen Ausfiltern des zweiten Dithersignals (Dither B) angeordnet ist.

8. Messvorrichtung nach einem der Ansprüche 1 bis 7,
**dadurch gekennzeichnet,**
**dass** zwischen dem Detektor (2) und dem Analog/DigitalWandler (6) ein Zerhacker (10) und zwischen dem Analog/Digital-Wandler (6) und der Auswerteeinrichtung (8, 9) ein Synchrondemodulator (14) angeordnet ist.

9. Messvorrichtung nach einem der Ansprüche 1 bis 8,
**dadurch gekennzeichnet,**
**dass** zwischen dem Analog/Digital-Wandler (6) und der Auswerteeinrichtung (8, 9) eine Einrichtung (7, 12) zur Korrektur eines Nullpunktversatzes angeordnet ist.

10. Messverfahren zum Messen der Hüllkurvenleistung und des Leistungsmittelwerts eines Hochfrequenzsignals mit den Verfahrensschritten
Erzeugen eines analogen Detektorsignals durch Detektieren des Hochfrequenzsignals,
Analog/Digital-Wandeln und Erzeugen eines digitalen Signals mittelbar oder unmittelbar aus dem Detektorsignal, und Auswerten des digitalen Signals,
**dadurch gekennzeichnet,**
**dass** vor dem Analog/Digital-Wandeln ein Dithersignal eingespeist wird, wobei für die Messung der Hüllkurvenleistung ein anderes Dithersignal als für die Messung des Leistungsmittelwerts eingespeist wird und wobei für die Messung der Hüllkurvenleistung ein erstes Dithersignal (Dither A) eingespeist wird, welches während der Aufnahme einer aus mehreren Messwerten der Hüllkurvenleistung bestehenden Messwertereihe nicht verändert wird, aber zwischen den Aufnahmen der Messwertereihen mit einer großen Amplitude variiert wird, und
wobei für die Messung des Leistungsmittelwerts ein zweites Dithersignal (Dither B) eingespeist wird, das kontinuierlich variiert wird.

11. Messverfahren nach Anspruch 10,
**dadurch gekennzeichnet,**
**dass** das erste Dithersignal (Dither A) über einen Digital/Analog-Wandler (23) aus einer zyklischen Digitalwertefolge erzeugt wird, wobei benachbarte Digitalwerte der Digitalwertefolge im statistischen Mittel einen relativ großen Werteunterschied haben.

12. Messverfahren nach Anspruch 11,
**dadurch gekennzeichnet,**
**dass** die zyklische Digitalwertefolge mittels eines Zählers (21) erzeugt wird, wobei das höchstsignifikanteste Bit (MSB) jedes von dem Zähler (21) erzeugten Digitalwerts als niedrigstsignifikantestes Bit (LSB) für die Digital/Analog-Wandlung und das niedrigstsignifikanteste Bit (LSB) jedes von dem Zähler (21) erzeugten Digitalwerts als höchstsignifikantestes Bit (MSB) für die Digital/Analog-Wandlung benutzt wird.

13. Messverfahren nach einem der Ansprüche 10 bis 12,
**dadurch gekennzeichnet,**
**dass** das erste Dithersignal (Dither A) nach dem Analog/Digital-Wandeln wieder eliminiert wird.

14. Messverfahren nach Anspruch 13,
**dadurch gekennzeichnet,**
**dass** das zweite Dithersignal (Dither B) innerhalb einer vorgegebenen Bandbreite um eine vorgegebene Mittenfrequenz (f_{M}) durch eine Phasenmodulation variiert wird.

15. Messverfahren nach Anspruch 14,
**dadurch gekennzeichnet,**
**dass** es sich bei dem zweiten Dithersignal (Dither B) um ein phasenmoduliertes Sinussignal handelt.

16. Messverfahren nach Anspruch 14 oder 15,
**dadurch gekennzeichnet,**
**dass** das zweite Dithersignal (Dither B) mittels einer Bandsperre (15) beseitigt wird.

17. Messverfahren nach einem der Ansprüche 10 bis 16,
**dadurch gekennzeichnet,**
**dass** das Detektorsignal vor der Analog/Digital-Wandlung zerhackt wird und nach der Analog/Digital-Wandlung synchrondemoduliert wird.

18. Messverfahren nach einem der Ansprüche 10 bis 17,
**dadurch gekennzeichnet,**
**dass** nach der Analog/Digital-Wandlung eine Korrektur eines Nullpunktversatzes erfolgt.

## Claims

1. Measuring device for measuring the envelope power and the mean-power value of a high-frequency signal with a detector (2) for detecting the high-frequency signal and for generating an analog detector signal, an analog-digital converter (6) for generating a digital signal and an evaluation device (8, 9) for evaluating the digital signal,
**characterised in that**
a dither-supply device (11) for the supply of a dither signal is disposed between the detector (2) and the analog-digital converter (6), wherein, for the measurement of the envelope power, the dither-supply device (11) supplies a different dither signal than for the measurement of the mean-power value, and
wherein, for the measurement of the envelope power, it supplies a first dither signal (Dither A), which is not varied during the recording of a measured-value series consisting of several measured values of the envelope power, but is varied with a large amplitude variation between the recordings of the measured-value series, and
wherein, for the measurement of the mean-power value, it supplies a second dither signal (Dither B), which is varied continuously.

2. Measuring device according to claim 1,
**characterised in that**
the first dither signal (Dither A) is generated via a digital-analog converter (23) from a cyclical digital-value sequence, wherein adjacent digital values of the digital-value sequence have a relatively-large value difference on statistical average.

3. Measuring device according to claim 2,
**characterised in that**
the cyclical digital-value sequence is generated by means of a counter (21), wherein the most significant bit (MSB) of every digital value generated by the counter (21) is used as the least significant bit (LSB) of the digital-analog converter (23), and the least significant bit (LSB) of every digital value generated by the counter (21) is used as the most significant bit (MSB) of the digital-analog converter (23).

4. Measuring device according to claim 2 or 3,
**characterised in that**
a dither-elimination device (13) for the elimination of the first dither signal (Dither A) is disposed between the analog-digital converter (6) and the evaluation device (8, 9).

5. Measuring device according to claim 1,
**characterised in that**
the second dither signal (Dither B) is generated by an oscillator (24), which is phase modulated by a phase modulator (25) within a predetermined bandwidth about a predetermined mid-frequency (f_{M}).

6. Measuring device according to claim 5,
**characterised in that**
the oscillator (24) generates a phase-modulated sinusoidal signal.

7. Measuring device according to claim 5 or 6,
**characterised in that**
a band-stop filter (15) for the at least partial filtering of the second dither signal (Dither B) is disposed between the analog-digital converter (6) and the evaluation device (8, 9).

8. Measuring device according to any one of claims 1 to 7,
**characterised in that**
a chopper (10) is disposed between the detector (2) and the analog-digital converter (6), and a synchronous demodulator (14) is disposed between the analog-digital converter (6) and the evaluation device (8, 9).

9. Measuring device according to any one of claims 1 to 8,
**characterised in that**
a device (7, 12) for the correction of a zero-point offset is disposed between the analog-digital converter (6) and the evaluation device (8, 9).

10. Measuring method for the measurement of the envelope power and the mean-power value of a high-frequency signal with the procedural stages: generation of an analog detector signal by detecting the high-frequency signal, analog-digital conversion and generation of a digital signal indirectly or directly from the detector signal,
and evaluation of the digital signal,
**characterised in that**
a dither signal is supplied before the analog-digital conversion, wherein, for the measurement of the envelope power, a different dither signal is supplied than for the measurement of the mean-power value, and
wherein, for the measurement of the envelope power, a first dither signal (Dither A) is supplied, which is not varied during the recording of a measured-value series consisting of several measured values of the envelope power, but is varied with a large amplitude between the recordings of the measured-value series, and
wherein, for the measurement of the mean-power value, a second dither signal (Dither B) is supplied, which is varied continuously.

11. Measuring method according to claim 10,
**characterised in that**
the first dither signal (Dither A) is generated via a digital-analog converter (23) from a cyclical digital-value sequence, wherein adjacent digital values of the digital-value sequence have a relatively-large value difference on statistical average.

12. Measuring method according to claim 11,
**characterised in that**
the cyclical digital-value sequence is generated by means of a counter (21), wherein the most significant bit (MSB) of every digital value generated by the counter (21) is used as the least significant bit (LSB) for the digital-analog conversion, and the least significant bit (LSB) of every digital value generated by the counter (21) is used as the most significant bit (MSB) for the digital-analog conversion.

13. Measuring method according to any one of claims 10 to 12,
**characterised in that**
the first dither signal (Dither A) is eliminated again after the analog-digital conversion.

14. Measuring method according to claim 13,
**characterised in that**
the second dither signal (Dither B) is varied by a phase modulation within a predetermined bandwidth about a predetermined mid-frequency (f_{M}).

15. Measuring method according to claim 14,
**characterised in that**
the second dither signal (Dither B) is a phase-modulated sinusoidal signal.

16. Measuring method according to claim 14 or 15,
**characterised in that**
the second dither signal (Dither B) is removed by means of a band-stop filter (15).

17. Measuring method according to any one of claims 10 to 16,
**characterised in that**
the detector signal is chopped before the analog-digital conversion and synchronously demodulated after the analog-digital conversion.

18. Measuring method according to any one of claims 10 to 17,
**characterised in that**
a correction of a zero-point offset is implemented after the analog-digital conversion.

## Revendications

1. Dispositif de mesure pour mesurer la puissance d'enveloppe et la valeur moyenne de puissance d'un signal haute fréquence, comprenant
un détecteur (2) pour détecter le signal haute fréquence et produire un signal de détecteur analogique,
un convertisseur analogique/numérique (6) pour produire un signal numérique, et
un dispositif de traitement (8, 9) pour traiter le signal numérique,
**caractérisé**
**en ce qu'**entre le détecteur (2) et le convertisseur analogique/numérique (6) est agencé un dispositif d'injection de "dither" (11) destiné à injecter un signal "dither" (signal de dispersion), le dispositif d'injection de "dither" (11) injectant pour la mesure de la puissance d'enveloppe un autre signal "dither" que pour la mesure de la valeur moyenne de puissance, à savoir qu'il injecte pour la mesure de la puissance d'enveloppe un premier signal "dither" ("dither" A), que l'on ne modifie pas pendant le relevé d'une série de valeurs de mesure constituée de plusieurs valeurs de mesure de la puissance d'enveloppe, mais que l'on modifie avec une grande variation d'amplitude entre les relevés des séries de valeurs de mesure, et qu'il injecte pour la mesure de la valeur moyenne de puissance un deuxième signal "dither" ("dither" B) que l'on fait varier de manière continue.

2. Dispositif de mesure selon la revendication 1,
**caractérisé**
**en ce que** le premier signal "dither" ("dither" A) est engendré par l'intermédiaire d'un convertisseur numérique/analogique (23) à partir d'une suite de valeurs numériques cyclique, des valeurs numériques voisines de la suite de valeurs numériques présentant une différence de valeur relativement grande en moyenne statistique.

3. Dispositif de mesure selon la revendication 2,
**caractérisé**
**en ce que** la suite de valeurs numériques cyclique est engendrée au moyen d'un compteur (21), le bit le plus significatif (MSB) de chaque valeur numérique engendrée par le compteur (21) étant utilisé en tant que bit le moins significatif (LSB) du convertisseur numérique/analogique (23), et le bit le moins significatif (LSB) de chaque valeur numérique engendrée par le compteur (21) en tant que bit le plus significatif (MSB) du convertisseur numérique/analogique (23).

4. Dispositif de mesure selon la revendication 2 ou 3,
**caractérisé**
**en ce qu'**entre le convertisseur analogique/numérique (6) et le dispositif de traitement (8, 9), est agencé un dispositif d'élimination de "dither" (13) pour éliminer le premier signal "dither" ("dither" A).

5. Dispositif de mesure selon la revendication 1,
**caractérisé**
**en ce que** le deuxième signal "dither" ("dither" B) est engendré par un oscillateur (24), qui à l'intérieur d'une largeur de bande prescrite est modulé en phase par un modulateur de phase (25), autour d'une fréquence centrale (f_{M}) prescrite.

6. Dispositif de mesure selon la revendication 5,
**caractérisé**
**en ce que** l'oscillateur (24) engendre un signal sinusoïdal modulé en phase.

7. Dispositif de mesure selon la revendication 5 ou 6,
**caractérisé**
**en ce qu'**entre le convertisseur analogique/numérique (6) et le dispositif de traitement (8, 9), est agencé un coupe-bande (15) pour le filtrage au moins partiel du deuxième signal "dither" ("dither" B).

8. Dispositif de mesure selon l'une des revendications 1 à 7,
**caractérisé**
**en ce qu'**entre le détecteur (2) et le convertisseur analogique/numérique (6) est agencé un hacheur (10), et entre le convertisseur analogique/numérique (6) et le dispositif de traitement (8, 9) un démodulateur synchrone (14).

9. Dispositif de mesure selon l'une des revendications 1 à 8,
**caractérisé**
**en ce qu'**entre le convertisseur analogique/numérique (6) et le dispositif de traitement (8, 9) est agencé un dispositif (7, 12) pour la correction d'un décalage du zéro.

10. Procédé de mesure pour mesurer la puissance d'enveloppe et la valeur moyenne de puissance d'un signal haute fréquence, comprenant les étapes suivantes :
production d'un signal analogique de détecteur par détection du signal haute fréquence,
conversion analogique/numérique et production d'un signal numérique indirectement ou directement à partir du signal de détecteur,
et traitement du signal numérique,
**caractérisé**
**en ce qu'**avant la conversion analogique/numérique, on injecte un signal "dither", un autre signal "dither" étant injecté pour la mesure de la puissance d'enveloppe que pour la mesure de la valeur moyenne de puissance, et pour la mesure de la puissance d'enveloppe on injecte un premier signal "dither" ("dither" A), que l'on ne modifie pas pendant le relevé d'une série de valeurs de mesure constituée de plusieurs valeurs de mesure de la puissance d'enveloppe, mais que l'on modifie avec une grande variation d'amplitude entre les relevés des séries de valeurs de mesure, et on injecte pour la mesure de la valeur moyenne de puissance un deuxième signal "dither" ("dither" B) que l'on fait varier de manière continue.

11. Procédé de mesure selon la revendication 10,
**caractérisé**
**en ce que** le premier signal "dither" ("dither" A) est engendré par l'intermédiaire d'un convertisseur numérique/analogique (23) à partir d'une suite de valeurs numériques cyclique, des valeurs numériques voisines de la suite de valeurs numériques présentant une différence de valeur relativement grande en moyenne statistique.

12. Procédé de mesure selon la revendication 11,
**caractérisé**
**en ce que** la suite de valeurs numériques cyclique est engendrée au moyen d'un compteur (21), le bit le plus significatif (MSB) de chaque valeur numérique engendrée par le compteur (21) étant utilisé en tant que bit le moins significatif (LSB) pour la conversion numérique/analogique, et le bit le moins significatif (LSB) de chaque valeur numérique engendrée par le compteur (21) en tant que bit le plus significatif (MSB) pour la conversion numérique/analogique.

13. Procédé de mesure selon l'une des revendications 10 à 12,
**caractérisé**
**en ce que** le premier signal "dither" ("dither" A) est à nouveau éliminé après la conversion analogique/numérique.

14. Procédé de mesure selon la revendication 13,
**caractérisé**
**en ce qu'**on fait varier le deuxième signal "dither" ("dither" B) par une modulation de phase à l'intérieur d'une largeur de bande prescrite, autour d'une fréquence centrale (f_{M}) prescrite.

15. Procédé de mesure selon la revendication 14,
**caractérisé**
**en ce que** pour le deuxième signal "dither" ("dither" B), il s'agit d'un signal sinusoïdal modulé en phase.

16. Procédé de mesure selon la revendication 14 ou 15,
**caractérisé**
**en ce que** le deuxième signal "dither" ("dither" B) est supprimé au moyen d'un coupe-bande (15).

17. Procédé de mesure selon l'une des revendications 10 à 16,
**caractérisé**
**en ce que** le signal de détecteur est haché avant la conversion analogique/numérique, et démodulé de manière synchrone après la conversion analogique/numérique.

18. Procédé de mesure selon l'une des revendications 10 à 17,
**caractérisé**
**en ce qu'**après la conversion analogique/numérique on effectue une correction de décalage du zéro.
